# EUROPÄISCHE PATENTANMELDUNG

(11) **EP 3 059 760 A1**
(43) Veröffentlichungstag der Anmeldung: **24.08.2016**
(21) Anmeldenummer: 15155500.0
(22) Anmeldetag: 18.02.2015
(51) Int. Cl.: H01L 23/34

(54) **Elektronische Vorrichtung**

(71) Anmelder: Siemens Aktiengesellschaft, 80333 München (DE)
(72) Erfinder: Oude Nijeweme, Rob, 91245 Simmelsdorf (DE); Schmidt, Roland, 74357 Bönnigheim (DE)

(57) **Zusammenfassung**

Die Erfindung betrifft eine elektronische Vorrichtung (1) mit wenigstens einem Bauelementträger (5,7), wenigstens einem auf einem Bauelementträger (5,7) angeordneten elektronischen Bauelement (9) und wenigstens einem in die elektronische Vorrichtung (1) integrierten elektrischen Heizelement (11,13).

## Beschreibung

Die Erfindung betrifft eine elektronische Vorrichtung mit wenigstens einem Bauelementträger und wenigstens einem auf einem Bauelementträger angeordneten elektronischen Bauelement.

Insbesondere betrifft die Erfindung elektronische Vorrichtungen, die als leistungselektronische Halbleitermodule, beispielsweise für Umrichter, ausgebildet sind und anspruchsvollen Umgebungsbedingungen, insbesondere tiefen Temperaturen oder einer hohen Luftfeuchtigkeit, ausgesetzt werden. Derartige Umgebungsbedingungen können die Funktionsweise elektronischer Bauteile beeinträchtigen, insbesondere bei einem Einschalten der Bauteile.

Um die Beeinträchtigung elektronischer Bauteile durch widrige Umgebungsbedingungen zu verhindern, wird häufig versucht, die Umgebungsbedingungen selbst zu verbessern bzw. Umgebungsbedingungen, die die Funktion elektronischer Bauteile beeinträchtigen, zu vermeiden. Beispielsweise werden elektronische Vorrichtungen dazu in einen geschlossenen Raum, ein Gehäuse oder einen Schaltkasten eingebaut, der die elektronische Vorrichtung vor widrigen Umgebungsbedingungen schützt oder dessen Feuchte und Temperatur geregelt werden.

Der Erfindung liegt die Aufgabe zugrunde, eine elektronische Vorrichtung anzugeben, die insbesondere hinsichtlich ihrer Verwendung bei widrigen Umgebungsbedingungen verbessert ist.

Die Aufgabe wird erfindungsgemäß durch die Merkmale des Anspruchs 1 gelöst.

Vorteilhafte Ausgestaltungen der Erfindung sind Gegenstand der Unteransprüche.

Eine erfindungsgemäße elektronische Vorrichtung umfasst wenigstens einen Bauelementträger, wenigstens ein auf einem Bauelementträger angeordnetes elektronisches Bauelement und wenigstens ein in die elektronische Vorrichtung integriertes elektrisches Heizelement.

Die Integration wenigstens eines elektrischen Heizelements in die elektronische Vorrichtung ermöglicht vorteilhaft, die elektronische Vorrichtung, insbesondere vor deren Inbetriebnahme, aufzuheizen. Dadurch können vorteilhaft die Temperatur innerhalb der elektronischen Vorrichtung erhöht und die Feuchtigkeit innerhalb der elektronischen Vorrichtung reduziert werden, um Beeinträchtigungen der Funktionsweise des wenigstens einen elektronischen Bauelements durch eine niedrige Temperatur und/oder hohe Feuchtigkeit zu verhindern. Insbesondere können dadurch die Funktionsstabilität und die Lebensdauer der elektronischen Vorrichtung erhöht werden, ohne die elektronische Vorrichtung in speziellen Umgebungen betreiben zu müssen. Ein zusätzlicher Vorteil eines in die elektronische Vorrichtung integrierten Heizelements aus einem thermisch leitfähigen Material ergibt sich aus dessen Wärmeaufnahmefähigkeit im Betrieb der elektronischen Vorrichtung, wenn das Heizelement nicht zum Heizen, sondern zum Abführen von Verlustwärme aus der elektronischen Vorrichtung genutzt wird, wodurch ebenfalls die Lebensdauer der elektronischen Vorrichtung erhöht werden kann. Eine erfindungsgemäße Integration eines elektrischen Heizelements ist auch bei wassergekühlten elektronischen Vorrichtungen vorteilhaft, da eine Wasserkühlung eine höhere Feuchtigkeit in der elektronischen Vorrichtung verursachen kann, wenn diese nicht betrieben wird, denn dieser erhöhten Feuchtigkeit kann durch eine Beheizung mittels des elektrischen Heizelements vor der Inbetriebnahme der elektronischen Vorrichtung entgegengewirkt werden.

Ausgestaltungen der Erfindung sehen vor, dass wenigstens ein elektrisches Heizelement an einer Außenseite eines Bauelementträgers angeordnet oder in einen Bauelementträger eingebettet oder zwischen mehreren Bauelementträgern angeordnet ist. Besonders bevorzugt ist dabei eine Anordnung wenigstens eines elektrischen Heizelements in der Nähe eines elektronischen Bauelements.

Diese Ausgestaltungen ermöglichen eine zweckmäßige Anordnung der Heizelemente an oder in Bauelementträgern. Eine Anordnung eines elektrischen Heizelements in der Nähe eines elektronischen Bauelements ist besonders vorteilhaft, da dadurch in der Nähe des elektronischen Bauelements besonders effizient die Temperatur erhöht und die Feuchtigkeit reduziert werden können.

Weitere Ausgestaltungen der Erfindung sehen vor, dass wenigstens ein elektrisches Heizelement als eine Heizfolie oder als eine metallische Heizplatte oder als ein elektrischer Heizwiderstand ausgebildet ist.

Diese Ausgestaltungen sind vorteilhaft, da Heizfolien, metallische Heizplatten und elektrische Heizwiderstände effiziente Beheizungen einer elektronischen Vorrichtung mittels kleiner elektrischer Leistungen ermöglichen.

Eine weitere Ausgestaltung der Erfindung sieht einen Träger vor, an dem wenigstens ein Bauelementträger angeordnet ist. Vorzugsweise ist der Träger dabei als eine metallische oder keramische oder aus einem Metallmatrix-Verbundwerkstoff (MMC = Metal Matrix Composite) gefertigte Grundplatte ausgebildet. Ferner kann wenigstens ein elektrisches Heizelement an einer Außenoberfläche des Trägers angeordnet oder in den Träger eingebettet sein.

Ein Träger, insbesondere ein als eine metallische oder keramische oder aus einem Metallmatrix-Verbundwerkstoff gefertigte Grundplatte ausgebildeter Träger, erhöht vorteilhaft die mechanische Stabilität der elektronischen Vorrichtung, vereinfacht deren Montage und verbessert die Wärmeabführung aus der elektronischen Vorrichtung. Die Anordnung eines elektrischen Heizelements an oder in dem Träger ermöglicht die Nutzung des Trägers zur Integration eines Heizelements in die elektronische Vorrichtung.

Weitere Ausgestaltungen der Erfindung sehen vor, dass wenigstens ein elektronisches Bauelement ein Halbleitertransistor, insbesondere ein Bipolartransistor mit isolierter Gate-Elektrode oder ein Halbleiter-Feldeffekttransistor, oder eine Halbleiterdiode oder ein Halbleiterthyristor oder ein Diac (= Diode for Alternating Current) oder ein Triac (= Triode for Alternating Current) oder ein Varistor ist.

Diese Ausgestaltungen der Erfindung sind vorteilhaft, da elektronische Vorrichtungen, die widrigen Umgebungsbedingungen ausgesetzt sind, häufig wenigstens eines der genannten elektronischen Bauelemente enthalten, und daher besonders von einer Beheizbarkeit mittels integrierter elektrischer Heizelemente profitieren.

Eine weitere Ausgestaltung der Erfindung sieht vor, dass wenigstens ein Bauelementträger einen keramischen oder aus einem Kunststoff gefertigten Grundkörper aufweist. Vorzugsweise ist dabei eine Außenoberfläche des keramischen oder aus einem Kunststoff gefertigten Grundkörpers wenigstens eines Bauelementträgers wenigstens teilweise mit einem Metall, insbesondere mit Kupfer oder Aluminium oder Silber oder Gold oder Nickel oder Zinn, beschichtet.

Bauelementträger mit keramischen oder aus einem Kunststoff gefertigten Grundkörpern sind vorteilhaft, da geeignete keramische Materialien und Kunststoffe elektrisch isolierend und gut wärmeleitend sind. Eine metallische Beschichtung eines derartigen Grundkörpers erleichtert insbesondere die Anordnung elektronischer Bauelemente an dem Bauelementträger sowie die Verbindung des Bauelementträgers mit einem metallischen Träger, beispielsweise mittels eines geeigneten Verbundmittels, z.B. eines Löt- oder Sintermittels.

Eine weitere Ausgestaltung der Erfindung sieht vor, dass wenigstens ein elektrisches Heizelement mit wenigstens einem elektrischen Kontaktelement zur elektrischen Kontaktierung des Heizelements verbunden ist.

Dies ermöglicht vorteilhaft die elektrische Kontaktierung wenigstens eines elektrischen Heizelements zur Beheizung der elektronischen Vorrichtung.

Eine weitere Ausgestaltung der Erfindung sieht einen Umrichter vor, der als eine erfindungsgemäße elektronische Vorrichtung ausgebildet ist.

Umrichter werden häufig widrigen Umgebungsbedingungen ausgesetzt und profitieren daher insbesondere von einer Beheizbarkeit mittels integrierter elektrischer Heizelemente.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: eine Schnittdarstellung eines ersten Ausführungsbeispiels einer elektronischen Vorrichtung,
- FIG 2: einen Ausschnitt einer Schnittdarstellung eines zweiten Ausführungsbeispiels einer elektronischen Vorrichtung, und
- FIG 3: einen Ausschnitt einer Schnittdarstellung eines dritten Ausführungsbeispiels einer elektronischen Vorrichtung.

Einander entsprechende Teile sind in allen Figuren mit den gleichen Bezugszeichen versehen.

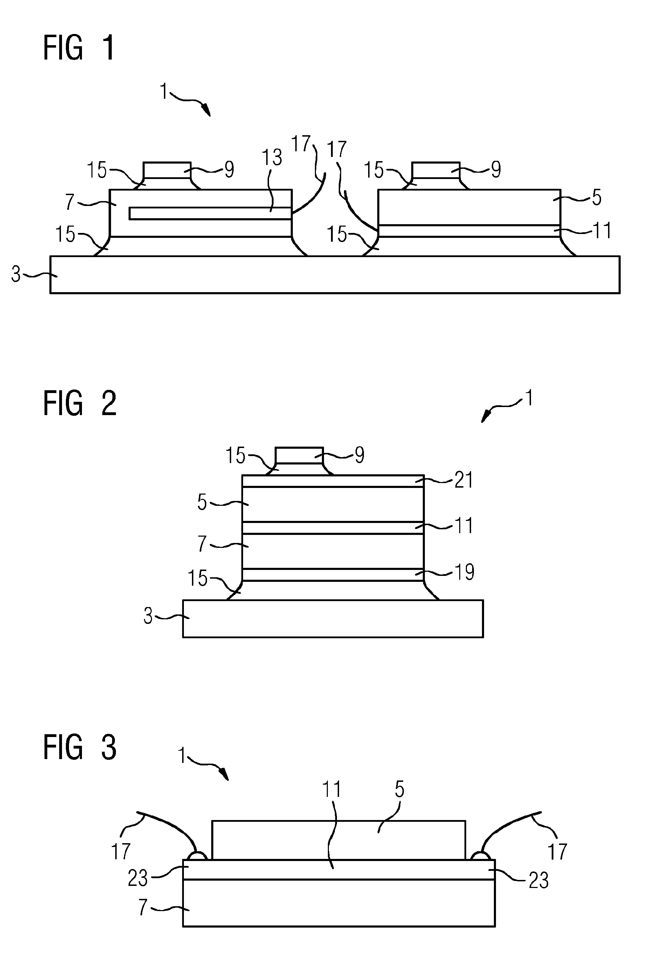

FIG 1 zeigt eine Schnittdarstellung eines ersten Ausführungsbeispiels einer elektronischen Vorrichtung 1. Die elektronische Vorrichtung 1 ist beispielsweise als ein Umrichter ausgebildet und umfasst einen Träger 3, mehrere Bauelementträger 5, 7, mehrere elektronische Bauelemente 9 und mehrere elektrische Heizelemente 11, 13.

Der Träger 3 ist als eine metallische oder keramische oder aus einem Metallmatrix-Verbundwerkstoff gefertigte Grundplatte ausgebildet.

Die elektrischen Heizelemente 11, 13 sind in die elektronische Vorrichtung 1 integriert und jeweils als eine Heizfolie oder eine metallische Heizplatte ausgebildet.

Die Bauelementträger 5, 7 weisen jeweils einen keramischen oder aus einem Kunststoff gefertigten Grundkörper auf, dessen Außenoberfläche wenigstens teilweise mit einem Metall, insbesondere mit Kupfer, Aluminium, Silber, Gold, Nickel oder Zinn, beschichtet sein kann.

Die elektronischen Bauelemente 9 sind jeweils beispielsweise als ein Halbleitertransistor, insbesondere als ein Bipolartransistor mit isolierter Gate-Elektrode oder ein Halbleiter-Feldeffekttransistor, oder als eine Halbleiterdiode oder ein Halbleiterthyristor oder ein Diac oder ein Triac oder ein Varistor ausgebildet.

Ein erstes elektrisches Heizelement 11 ist mittels eines Verbundmittels 15, beispielsweise eines Löt- oder Sintermittels, mit dem Träger 3 verbunden und an einer trägerseitigen Außenseite eines ersten Bauelementträgers 5 angeordnet und mit diesem beispielsweise verklebt oder verschweißt. Ein zweites elektrisches Heizelement 13 ist in einen zweiten Bauelementträger 7 eingebettet, der mittels des Verbundmittels 15 mit dem Träger 3 verbunden ist. Die elektrischen Heizelemente 11, 13 sind jeweils mit wenigstens einem elektrischen Kontaktelement 17 zur elektrischen Kontaktierung des Heizelements 11, 13 verbunden. Die elektrischen Kontaktelemente 17 sind beispielsweise jeweils als ein elektrisch leitfähiger Draht ausgebildet und mit dem jeweiligen elektrischen Heizelement 11, 13 beispielsweise durch Drahtbonden, Reibschweißen oder Löten oder Sintern verbunden.

Die elektronischen Bauelemente 9 sind jeweils auf einem Bauelementträger 5, 7 angeordnet und mit dieser mittels des Verbundmittels 15 verbunden.

FIG 2 zeigt einen Ausschnitt einer Schnittdarstellung eines zweiten Ausführungsbeispiels einer elektronischen Vorrichtung 1. Dieses Ausführungsbeispiel unterscheidet sich von dem in FIG 1 dargestellten ersten Ausführungsbeispiel im Wesentlichen dadurch, dass es ein elektrisches Heizelement 11 aufweist, das zwischen zwei Bauelementträgern 5, 7 angeordnet ist und an diesen jeweils beispielsweise gepresst oder geklebt oder gelötet oder gesintert oder geschweißt ist. Ferner ist eine von diesem elektrischen Heizelement 11 abgewandte Seite jeder dieser Bauelementträger 5, 7 mit einer Metallschicht 19, 21 beispielsweise einer Kupfer-, Silber-, Gold-, Nickel-, Zinn- oder Aluminiumschicht, beschichtet. Eine erste Metallschicht 19 ist mittels des Verbundmittels 15 mit dem Träger 3 verbunden. Auf der zweiten Metallschicht 21 ist mittels des Verbundmittels 15 ein elektronisches Bauelement 9 befestigt.

FIG 3 zeigt einen Ausschnitt einer Schnittdarstellung eines dritten Ausführungsbeispiels einer elektronischen Vorrichtung 1, wobei nur zwei Bauelementträger 5, 7 und ein dazwischen angeordnetes elektrisches Heizelement 11 dargestellt sind. Im Unterschied zu dem in FIG 2 dargestellten zweiten Ausführungsbeispiel weist ein erster Bauelementträger 5 eine kleinere Breite als das elektrische Heizelement 11 und der zweite Bauelementträger 7 auf, so dass zwei sich gegenüberliegende seitliche Randbereiche 23 des elektrischen Heizelements 11 über den ersten Bauelementträger 5 überstehen. Jeder dieser Randbereiche 23 ist mit einem als ein Bonddraht ausgebildeten elektrischen Kontaktelement 17 verbunden. Statt als ein Bonddraht kann ein Kontaktelement 17 auch beispielsweise als ein Metallstreifen oder ein Metallstift ausgebildet sein. Abgesehen davon ist die elektronische Vorrichtung 1 des dritten Ausführungsbeispiels analog zu dem in FIG 2 dargestellten zweiten Ausführungsbeispiel ausgebildet.

In jede der in den Figuren 1 bis 3 dargestellten elektronischen Vorrichtungen 1 können weitere elektrische Heizelemente 11, 13, die als Heizwiderstände ausgebildet sind, integriert sein. Ferner kann wenigstens ein elektrisches Heizelement 11, 13 in den Träger 3 eingebettet sein.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Elektronische Vorrichtung (1), umfassend
- wenigstens einen Bauelementträger (5,7),
- wenigstens ein auf einem Bauelementträger (5,7) angeordnetes elektronisches Bauelement (9)
- und wenigstens ein in die elektronische Vorrichtung (1) integriertes elektrisches Heizelement (11,13).

2. Elektronische Vorrichtung (1) nach Anspruch 1, **dadurch gekennzeichnet, dass** wenigstens ein elektrisches Heizelement (11,13) an einer Außenseite eines Bauelementträgers (5,7) angeordnet ist.

3. Elektronische Vorrichtung (1) nach einem der vorhergehenden Ansprüche, **dadurch gekennzeichnet, dass** wenigstens ein elektrisches Heizelement (11,13) in einen Bauelementträger (5,7) eingebettet ist.

4. Elektronische Vorrichtung (1) nach einem der vorhergehenden Ansprüche, **dadurch gekennzeichnet, dass** wenigstens ein elektrisches Heizelement (11,13) zwischen mehreren Bauelementträgern (5,7) angeordnet ist.

5. Elektronische Vorrichtung (1) nach einem der vorhergehenden Ansprüche, **dadurch gekennzeichnet, dass** wenigstens ein elektrisches Heizelement (11,13) als eine Heizfolie ausgebildet ist.

6. Elektronische Vorrichtung (1) nach einem der vorhergehenden Ansprüche, **dadurch gekennzeichnet, dass** wenigstens ein elektrisches Heizelement (11,13) als eine metallische Heizplatte ausgebildet ist.

7. Elektronische Vorrichtung (1) nach einem der vorhergehenden Ansprüche, **dadurch gekennzeichnet, dass** wenigstens ein elektrisches Heizelement (11,13) als ein elektrischer Heizwiderstand ausgebildet ist.

8. Elektronische Vorrichtung (1) nach einem der vorhergehenden Ansprüche, **gekennzeichnet durch** einen Träger (3), an dem wenigstens ein Bauelementträger (5,7) angeordnet ist.

9. Elektronische Vorrichtung (1) nach Anspruch 7, **dadurch gekennzeichnet, dass** der Träger (3) als eine metallische oder keramische oder aus einem Metallmatrix-Verbundwerkstoff gefertigte Grundplatte ausgebildet ist.

10. Elektronische Vorrichtung (1) nach Anspruch 8 oder 9, **dadurch gekennzeichnet, dass** wenigstens ein elektrisches Heizelement (11,13) an einer Außenoberfläche des Trägers (3) angeordnet oder in den Träger (3) eingebettet ist.

11. Elektronische Vorrichtung (1) nach einem der vorhergehenden Ansprüche, **dadurch gekennzeichnet, dass** wenigstens ein elektronisches Bauelement (9) ein Halbleitertransistor, insbesondere ein Bipolartransistor mit isolierter Gate-Elektrode oder ein Halbleiter-Feldeffekttransistor, oder eine Halbleiterdiode oder ein Halbleiterthyristor oder ein Diac oder ein Triac oder ein Varistor ist.

12. Elektronische Vorrichtung (1) nach einem der vorhergehenden Ansprüche, **dadurch gekennzeichnet, dass** wenigstens ein Bauelementträger (5,7) einen keramischen oder aus einem Kunststoff gefertigten Grundkörper aufweist.

13. Elektronische Vorrichtung (1) nach Anspruch 12, **dadurch gekennzeichnet, dass** eine Außenoberfläche des keramischen oder aus einem Kunststoff gefertigten Grundkörpers wenigstens eines Bauelementträgers (5,7) wenigstens teilweise mit einem Metall, insbesondere mit Kupfer oder Aluminium oder Silber oder Gold oder Nickel oder Zinn, beschichtet ist.

14. Elektronische Vorrichtung (1) nach einem der vorhergehenden Ansprüche, **dadurch gekennzeichnet, dass** wenigstens ein elektrisches Heizelement (11,13) mit wenigstens einem elektrischen Kontaktelement (17) zur elektrischen Kontaktierung des Heizelements (11,13) verbunden ist.

15. Umrichter, der als eine elektronische Vorrichtung (1) nach einem der vorhergehenden Ansprüche ausgebildet ist.
